# EUROPEAN PATENT APPLICATION

(11) **EP 4 661 082 A1**
(43) Date of publication of application: **10.12.2025**
(21) Application number: 24749964.3
(22) Date of filing: 18.01.2024
(51) Int. Cl.: H01L 31/08

(54) **METHOD FOR MANUFACTURING LIGHT-DETECTING ELEMENT AND METHOD FOR MANUFACTURING IMAGE SENSOR**

(30) Priority: 30.01.2023 JP 2023012289
(71) Applicant: FUJIFILM Corporation, Tokyo 106-8620 (JP)
(72) Inventor: GOTO, Takashi, Haibara-gun, Shizuoka 421-0396 (JP); TABUCHI, Atsuko, Haibara-gun, Shizuoka 421-0396 (JP); SAWAMURA, Yasuhiro, Haibara-gun, Shizuoka 421-0396 (JP)
(74) Representative: HGF
(86) International application number: PCT/JP2024/001180
(87) International publication number: WO 2024/162010

(57) **Abstract**

A method for manufacturing a photodetector and a method for manufacturing an image sensor includes forming a first electrode on a support; filtering a quantum dot dispersion liquid containing quantum dots having a maximal absorption in terms of absorbance in a wavelength range of 900 to 1700 nm, a ligand, and a solvent, and forming a semiconductor film containing quantum dots on the first electrode by using the filtered quantum dot dispersion liquid; and forming a second electrode on the semiconductor film.

## Description

### BACKGROUND OF THE INVENTION

### 1. Field of the Invention

The present invention relates to a method for manufacturing a photodetector including a semiconductor film containing quantum dots and a method for manufacturing an image sensor.

### 2. Description of the Related Art

A substance reduced to a size of several nanometers to several tens of nanometers exhibits physical properties different from those in a bulk state. Such a phenomenon is called a quantum size effect, and a substance in which such an effect is exhibited is called a quantum dot. A change in size of the quantum dot makes it possible to adjust a band gap thereof (a light absorption wavelength or a luminescence wavelength).

In recent years, research on the quantum dot has advanced. For example, as described in WO2017/150167A, use of the quantum dots as a material for a photodetector is being studied.

### SUMMARY OF THE INVENTION

In recent years, with the demand for performance improvement of an image sensor and the like, there is a demand for further improvement of various characteristics that are required in a photodetector used in the image sensor and the like. For example, characteristics required for a photodetector include low dark current.

Therefore, an object of the present invention is to provide a method for manufacturing a photodetector, in which a photodetector in which the dark current is reduced can be manufactured with high yield. In addition, another object of the present invention is to provide a method for manufacturing an image sensor.

The present invention provides the following aspects.
<1> A method for manufacturing a photodetector, comprising:
   forming a first electrode on a support;
   filtering a quantum dot dispersion liquid containing quantum dots having a maximal absorption in terms of absorbance in a wavelength range of 900 to 1700 nm, a ligand, and a solvent, and forming a semiconductor film containing the quantum dots on the first electrode by using the filtered quantum dot dispersion liquid; and
   forming a second electrode on the semiconductor film.
<2> The method for manufacturing a photodetector according to <1>,
   in which in the quantum dot dispersion liquid, a content of the quantum dots in a component obtained by removing the solvent and the ligand from the quantum dot dispersion liquid is 50% by mass or more.
<3> The method for manufacturing a photodetector according to<1> or <2>,
   in which a pore diameter of a filter used for filtering the quantum dot dispersion liquid is less than 0.45 µm.
<4> The method for manufacturing a photodetector according to any one of <1> to <3>,
   in which a material of a filter used for filtering the quantum dot dispersion liquid includes at least one selected from a fluororesin, a polyamide, or polyethylene terephthalate.
<5> The method for manufacturing a photodetector according to any one of <1> to <4>,
   in which the quantum dots contain at least one atom selected from the group consisting of Ga, Ge, As, Se, In, Sb, Ag, Te, and Bi.
<6> The method for manufacturing a photodetector according to any one of <1> to <5>,
   in which the ligand includes at least one selected from an inorganic ligand or a compound having 7 or less carbon atoms.
<7> The method for manufacturing a photodetector according to any one of <1> to <6>,
   in which the ligand includes an inorganic ligand, and the inorganic ligand is an inorganic halide.
<8> The method for manufacturing a photodetector according to any one of <1> to <7>,
   in which a number average particle diameter of the quantum dots is 4 nm or more.
<9> The method for manufacturing a photodetector according to any one of <1> to <8>,
   in which the second electrode is formed on the semiconductor film by a sputtering method.
<10> The method for manufacturing a photodetector according to any one of <1> to <9>,
   in which the second electrode contains indium tin oxide.
<11> A method for manufacturing an image sensor, including:
   the method for manufacturing a photodetector according to any one of <1> to <10>.

According to the present invention, a photodetector and an image sensor in which the dark current is reduced can be manufactured with high yield.

### DESCRIPTION OF THE PREFERRED EMBODIMENTS

Hereinafter, the details of the present invention will be described.

In the present specification, "to" is used to mean that numerical values described before and after "to" are included as a lower limit value and an upper limit value, respectively.

In describing a group (an atomic group) in the present specification, in a case where a description of substitution and non-substitution is not provided, the description means the group includes a group (an atomic group) having a substituent as well as a group (an atomic group) having no substituent. For example, the "alkyl group" includes not only an alkyl group that does not have a substituent (an unsubstituted alkyl group) but also an alkyl group that has a substituent (a substituted alkyl group).

### <Method for Manufacturing Photodetector>

The method for manufacturing a photodetector according to the embodiment of the present invention includes forming a first electrode on a support, filtering a quantum dot dispersion liquid containing quantum dots having a maximal absorption in terms of absorbance in a wavelength range of 900 to 1700 nm, a ligand, and a solvent, and forming a semiconductor film containing quantum dots on the first electrode by using the filtered quantum dot dispersion liquid, and forming a second electrode on the semiconductor film.

As a result of intensive studies on a quantum dot dispersion liquid used for forming the semiconductor film in the photodetector, the present inventors have found that, in a case where the quantum dot dispersion liquid is stored for a long period of time, soft aggregates of quantum dots tend to be easily formed in the quantum dot dispersion liquid. In addition, in order to increase the external quantum efficiency and the like, it is required that the distance between the quantum dots in the semiconductor film is close. Therefore, a quantum dot dispersion liquid used for forming the semiconductor film tends to use a ligand having a relatively small molecular size. However, it was found that in a case where a ligand having a small molecular size is used, soft aggregates of quantum dots tend to be easily formed in the quantum dot dispersion liquid. In a case where such a soft aggregate is included in the semiconductor film, the soft aggregate may form unevenness in the film, which may cause an increase in dark current. According to the present invention, by filtering the quantum dot dispersion liquid and forming a semiconductor film containing quantum dots on the first electrode using the filtered quantum dot dispersion liquid, it is possible to suppress the mixing of soft aggregates of quantum dots and the like in the semiconductor film, and to form a semiconductor film in which the generation of unevenness and the like is suppressed. Therefore, according to the present invention, a photodetector in which the dark current is reduced can be manufactured with high yield.

The photodetector manufactured according to the embodiment of the present invention is preferably a photodiode-type photodetector. Hereinafter, the method for manufacturing a photodetector according to the embodiment of the present invention will be described in more detail.

### <<Step of Forming First Electrode>>

In the step of forming the first electrode, the first electrode is formed on the support.

The support on which the first electrode is formed is not particularly limited. A glass substrate, a resin substrate, a ceramic substrate, and the like are exemplified. In a case where the first electrode is provided on a light incident side of the semiconductor film, it is preferable that the support is substantially transparent to the wavelength of the target light to be detected by the photodetector. Furthermore, in the present specification, the description of "substantially transparent" means that the transmittance of light is 50% or more, preferably 60% or more, and particularly preferably 80% or more.

Examples of a material for the first electrode include a metal, an alloy, a metal oxide, a metal nitride, a metal boride, and an organic conductive compound. Specific examples thereof include tin oxide, zinc oxide, indium oxide, indium tungsten oxide, indium zinc oxide (IZO), indium tin oxide (ITO), and fluorine-doped tin oxide (FTO). In a case where the first electrode is provided on the light incident side of the semiconductor film, it is preferable that the first electrode is a transparent electrode formed of a conductive material that is substantially transparent to the wavelength of the target light to be detected by the photodetector.

The first electrode can be formed by a method such as a vacuum deposition method, a sputtering method, or a chemical vapor deposition method (CVD method).

A thickness of the first electrode is preferably 10 to 100,000 nm. A lower limit thereof is preferably 30 nm or more, and more preferably 50 nm or more. An upper limit thereof is preferably 10,000 nm or less, and more preferably 1,000 nm or less. In the present specification, a thickness of each layer can be measured by observing a cross-section of the photodetector by using a scanning electron microscope or the like.

### <<Step of Forming Semiconductor Film>>

In the step of forming the semiconductor film, a quantum dot dispersion liquid containing quantum dots having a maximal absorption in terms of absorbance in a wavelength range of 900 to 1700 nm, a ligand, and a solvent is filtered, and a semiconductor film containing quantum dots is formed on the first electrode by using the filtered quantum dot dispersion liquid. This semiconductor film is used as a photoelectric conversion layer in the photodetector. In a case where another layer such as a charge transport layer or a blocking layer, which will be described later, is further formed on the first electrode, the semiconductor film is formed on the other layer after the other layer is formed.

A quantum dot dispersion liquid used for forming the semiconductor film will be described. The quantum dot dispersion liquid contains quantum dots having a maximal absorption in terms of absorbance in a wavelength range of 900 to 1700 nm, a ligand, and a solvent.

The quantum dots are preferably semiconductor particles including a metal atom. Furthermore, in the present specification, the metal atom also includes a metalloid atom typified by an Si atom. In addition, the "semiconductor" in the present specification means a substance having a specific resistance value of 10⁻² Ωcm or more and 10⁸ Ωcm or less.

Examples of the quantum dot material constituting the quantum dot include a nanoparticle (a particle having a size of 0.5 nm or more and less than 100 nm) of a general semiconductor crystal [a) a Group IV semiconductor, b) a compound semiconductor of Group IV-IV, Group III-V, or Group II-VI, or c) a compound semiconductor consisting of a combination of three or more of a Group II element, a Group III element, a Group IV element, a Group V element, and a Group VI element].

The quantum dots preferably contain at least one atom selected from the group consisting of Ga, Ge, As, Se, In, Sn, Sb, Te, Pb, Bi, Ag, Cu, and Hg, more preferably contain at least one atom selected from the group consisting of Ga, Ge, As, Se, In, Sb, Ag, Te, and Bi, still more preferably contain at least one atom selected from the group consisting of Ga, As, Se, In, Sb, Te, and Bi, and particularly preferably contain at least one atom selected from the group consisting of As, In, and Sb.

Specific examples of the quantum dot material constituting the quantum dot include semiconductor materials having a relatively narrow band gap, such as PbS, PbSe, PbSeS, InN, Ge, GeO₂, InAs, InGaAs, CuInS, CuInSe, CuInGaSe, InSb, InP, HgTe, HgCdTe, Ag₂S, Ag₂Se, Ag₂Te, SnS, SnSe, SnTe, Si, InP, AgBiS₂, AgBiSTe, AgBiSeTe, and lead perovskite. From the viewpoint of a large absorption coefficient of light in the infrared region, a long lifetime of photocurrent, and a large carrier mobility, the quantum dots are more preferably PbS, InAs, InSb, InGaAs, InP, Ge, GeO₂, AgBiS₂, AgBiSTe, or AgBiSeTe. The quantum dot dispersion liquid using InAs quantum dots tends to easily form a soft aggregate, and the effects of the present invention are more significantly exhibited.

It is preferable that the quantum dots have a maximal absorption in terms of absorbance in a wavelength range of 1300 to 1500 nm.

A band gap of the quantum dots is preferably 1.35 eV or less, more preferably 1.1 eV or less, and still more preferably 1.0 eV or less. A lower limit value of the band gap of the quantum dots is not particularly limited, but can be 0.5 eV or more. In a case where the band gap of the quantum dots is 1.35 eV, a quantum dot layer having a higher sensitivity to light at a wavelength in the infrared region can be formed. The band gap of the quantum dots can be calculated from the energy at the maximal absorption wavelength in an absorption spectrum obtained from light absorption measurement in a range from the visible region to the infrared region, by using an ultraviolet-visible-near infrared spectrophotometer. In addition, it can be determined from a Tauc plot as described in JP5949567B in a case of quantum dots having no maximal absorption wavelength.

The number average particle diameter of the quantum dots is preferably 1 nm or more, more preferably 2 nm or more, and still more preferably 4 nm or more. The upper limit value of the number average particle diameter of the quantum dots is preferably 20 nm or less, more preferably 15 nm or less, and still more preferably 10 nm or less. In a case where the number average particle diameter of the quantum dots is in the above-described range, it is possible to form a semiconductor film having higher sensitivity to light at a wavelength in the infrared region. Furthermore, in the present specification, the value of the number average particle diameter of the quantum dots is an average value of the particle diameters of ten quantum dots which are randomly selected. A transmission electron microscope may be used for measuring the particle diameter of the quantum dots.

The content of the quantum dots in the quantum dot dispersion liquid is preferably 1% to 25% by mass with respect to the total mass of the quantum dot dispersion liquid. The lower limit thereof is preferably 2% by mass or more and more preferably 3% by mass or more. The upper limit thereof is preferably 20% by mass or less.

In addition, the content of the quantum dots in the quantum dot dispersion liquid is preferably 1 to 500 mg/mL, more preferably 10 to 200 mg/mL, and still more preferably 20 to 100 mg/mL.

In addition, in the quantum dot dispersion liquid, the content of the quantum dots in the components obtained by removing the solvent and the ligand from the quantum dot dispersion liquid is preferably 50% by mass or more, more preferably 60% by mass or more, and still more preferably 70% by mass or more. The upper limit thereof may be 100% by mass or less.

In addition, a total content of the quantum dot and the ligand in a component obtained by removing the solvent from the quantum dot dispersion liquid is preferably 60% by mass or more, more preferably 70% by mass or more, and still more preferably 80% by mass or more. The upper limit thereof may be 100% by mass or less.

The quantum dot dispersion liquid contains a ligand. The ligand may be an organic ligand or an inorganic ligand.

The inorganic ligand is preferably an inorganic halide. The inorganic halide is easily coordinated to the quantum dot, and the generation of surface defects can be suppressed. Examples of the halogen atom contained in the inorganic halide include F, Cl, Br, and I, and Br is preferable.

The inorganic ligand preferably includes an atom contained in the quantum dot. For example, in a case where the quantum dot has InAs as a parent crystal, the inorganic ligand preferably contains at least one atom selected from In or As, and more preferably contains an In atom.

Specific examples of the inorganic ligand include zinc iodide, zinc bromide, zinc chloride, indium iodide, indium bromide, indium chloride, cadmium iodide, cadmium bromide, and cadmium chloride, gallium iodide, gallium bromide, gallium chloride, and ammonium chloride.

The organic ligand may be a monodentate organic ligand having one coordination moiety or may be a polydentate organic ligand having two or more coordination moieties. Examples of the coordination moiety included in the organic ligand include a thiol group, an amino group, a hydroxy group, a carboxy group, a sulfo group, a phosphoryl group, and a phosphonic acid group.

Examples of the polydentate ligand include a ligand represented by any of Formulae (A) to (C).

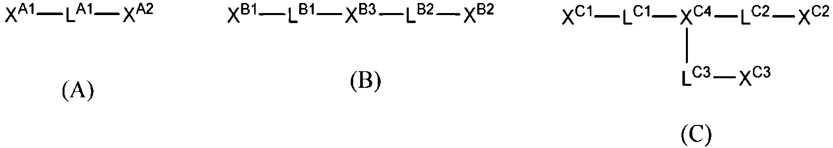

In Formula (A), X^{A1} and X^{A2} each independently represent a thiol group, an amino group, a hydroxy group, a carboxy group, a sulfo group, a phosphoryl group, or a phosphonic acid group, and L^{A1} represents a hydrocarbon group.

In Formula (B), X^{B1} and X^{B2} each independently represent a thiol group, an amino group, a hydroxy group, a carboxy group, a sulfo group, a phosphoryl group, or a phosphonic acid group, X^{B3} represents S, O, or NH, and L^{B1} and L^{B2} each independently represent a hydrocarbon group.

In Formula (C), X^{C1} to X^{C3} each independently represent a thiol group, an amino group, a hydroxy group, a carboxy group, a sulfo group, a phosphoryl group, or a phosphonic acid group, X^{C4} represents N, and L^{C1} to L^{C3} each independently represent a hydrocarbon group.

The amino group represented by X^{A1}, X^{A2}, X^{B1}, X^{B2,} X^{C 1}, X^{C2}, or X^{C3} is not limited to - NH₂ and includes a substituted amino group and a cyclic amino group as well. Examples of the substituted amino group include a monoalkylamino group, a dialkylamino group, a monoarylamino group, a diarylamino group, and an alkylarylamino group. The amino group represented by these groups is preferably -NH₂, a monoalkylamino group, or a dialkylamino group, and more preferably -NH₂.

The hydrocarbon group represented by L^{A1}, L^{B1}, L^{B2}, L^{C1}, L^{C2}, or L^{C3} is preferably an aliphatic hydrocarbon group or a group including an aromatic ring, and more preferably the aliphatic hydrocarbon group. The aliphatic hydrocarbon group may be a saturated aliphatic hydrocarbon group or may be an unsaturated aliphatic hydrocarbon group. The hydrocarbon group preferably has 1 to 20 carbon atoms. An upper limit of the number of carbon atoms is preferably 10 or less, more preferably 6 or less, and still more preferably 3 or less. Specific examples of the hydrocarbon group include an alkylene group, an alkenylene group, an alkynylene group, and an arylene group.

Examples of the alkylene group include a linear alkylene group, a branched alkylene group, and a cyclic alkylene group. The linear alkylene group or the branched alkylene group is preferable, and the linear alkylene group is more preferable. Examples of the alkenylene group include a linear alkenylene group, a branched alkenylene group, and a cyclic alkenylene group. The linear alkenylene group or the branched alkenylene group is preferable, and the linear alkenylene group is more preferable. Examples of the alkynylene group include a linear alkynylene group and a branched alkynylene group, and the linear alkynylene group is preferable. The arylene group may be either monocyclic or polycyclic. The monocyclic arylene group is preferable. Specific examples of the arylene group include a phenylene group and a naphthylene group, and the phenylene group is preferable. The alkylene group, the alkenylene group, the alkynylene group, and the arylene group may further have a substituent. The substituent is preferably a group having 1 or more and 10 or less atoms. Preferred specific examples of the group having 1 or more and 10 or less of atoms include an alkyl group having 1 to 3 carbon atoms [a methyl group, an ethyl group, a propyl group, and an isopropyl group], an alkenyl group having 2 or 3 carbon atoms [an ethenyl group and a propenyl group], an alkynyl group having 2 to 4 carbon atoms [an ethynyl group, a propynyl group, and the like], a cyclopropyl group, an alkoxy group having 1 or 2 carbon atoms [a methoxy group and an ethoxy group], an acyl group having 2 or 3 carbon atoms [an acetyl group and a propionyl group], an alkoxycarbonyl group having 2 or 3 carbon atoms [a methoxycarbonyl group and an ethoxycarbonyl group], an acyloxy group having 2 carbon atoms [an acetyloxy group], an acylamino group having 2 carbon atoms [an acetylamino group], a hydroxyalkyl group having 1 to 3 carbon atoms [a hydroxymethyl group, a hydroxyethyl group, and a hydroxypropyl group], an aldehyde group, a hydroxy group, a carboxy group, a sulfo group, a phosphoryl group, a carbamoyl group, a cyano group, an isocyanate group, a thiol group, a nitro group, a nitroxy group, an isothiocyanate group, a cyanate group, a thiocyanate group, an acetoxy group, an acetamide group, a formyl group, a formyloxy group, a formamide group, a sulfamino group, a sulfino group, a sulfamoyl group, a phosphono group, an acetyl group, a halogen atom, and an alkali metal atom.

In Formula (A), X^{A1} and X^{A2} are separated by L^{A1}, preferably by 1 to 10 atoms, more preferably by 1 to 6 atoms, still more preferably by 1 to 4 atoms, even still more preferably by 1 to 3 atoms, and particularly preferably by 1 or 2 atoms.

In Formula (B), X^{B1} and X^{B3} are separated by L^{B1}, preferably by 1 to 10 atoms, more preferably by 1 to 6 atoms, still more preferably by 1 to 4 atoms, even still more preferably by 1 to 3 atoms, and particularly preferably by 1 or 2 atoms. In addition, X^{B2} and X^{B3} are separated by L^{B2}, preferably by 1 to 10 atoms, more preferably by 1 to 6 atoms, still more preferably by 1 to 4 atoms, even still more preferably by 1 to 3 atoms, and particularly preferably by 1 or 2 atoms.

In Formula (C), X^{C1} and X^{C4} are separated by L^{C1}, preferably by 1 to 10 atoms, more preferably by 1 to 6 atoms, still more preferably by 1 to 4 atoms, even still more preferably by 1 to 3 atoms, and particularly preferably by 1 or 2 atoms. Furthermore, X^{C2} and X^{C4} are separated by L^{C2}, preferably by 1 to 10 atoms, more preferably by 1 to 6 atoms, still more preferably by 1 to 4 atoms, even still more preferably by 1 to 3 atoms, and particularly preferably by 1 or 2 atoms. In addition, X^{C3} and X^{C4} are separated by L^{C3}, preferably by 1 to 10 atoms, more preferably by 1 to 6 atoms, still more preferably by 1 to 4 atoms, even still more preferably by 1 to 3 atoms, and particularly preferably by 1 or 2 atoms.

Furthermore, the description that X^{A1} and X¹² are separated by L^{A1} by 1 to 10 atoms means that the number of atoms constituting a molecular chain having the shortest distance, linking X^{A1} and X^{A2}, is 1 to 10. For example, in a case of Formula (A1), X^{A1} and X^{A2} are separated by 2 atoms, and in cases of Formulae (A2) and (A3), X^{A1} and X^{A2} are separated by 3 atoms. The numbers added to the following structural formulae represent the arrangement order of atoms constituting a molecular chain having the shortest distance, linking X^{A1} and X^{A2}.

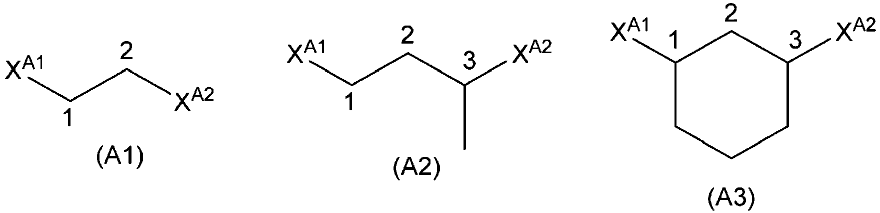

To explain with a specific compound, 3-mercaptopropionic acid is a compound (a compound having the following structure) having a structure in which a moiety corresponding to X^{A1} is a carboxy group, a moiety corresponding to X^{A2} is a thiol group, and a moiety corresponding to L^{A1} is an ethylene group. In 3-mercaptopropionic acid, X^{A1} (carboxy group) and X^{A2} (thiol group) are separated by L^{A1} (ethylene group) by 2 atoms.

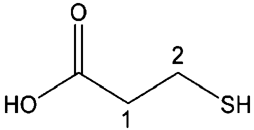

The same applies to the meanings that X^{B1} and X^{B3} are separated by L^{B1} by 1 to 10 atoms, X^{B2} and X^{B3} are separated by L^{B2} by 1 to 10 atoms, X^{C1} and X^{C4} are separated by L^{C1} by 1 to 10 atoms, X^{C2} and X^{C4} are separated by L^{C2} by 1 to 10 atoms, and X^{C3} and X^{C4} are separated by L^{C3} by 1 to 10 atoms.

Specific examples of the polydentate ligand include 3-mercaptopropionic acid, thioglycolic acid, 2-aminoethanol, 2-aminoethanethiol, 2-mercaptoethanol, glycolic acid, ethylene glycol, ethylenediamine, aminosulfonic acid, glycine, aminomethylphosphoric acid, guanidine, diethylenetriamine, tris(2-aminoethyl)amine, 4-mercaptobutanoic acid, 3-aminopropanol, 3-mercaptopropanol, N-(3-aminopropyl)-1,3-propanediamine, 3-(bis(3-aminopropyl)amino)propan-1-ol, 1-thioglycerol, dimercaprol, 1-mercapto-2-butanol, 1-mercapto-2-pentanol, 3-mercapto-1-propanol, 2,3-dimercapto-1-propanol, diethanolamine, 2-(2-aminoethyl)aminoethanol, dimethylenetriamine, 1,1-oxybismethylamine, 1,1-thiobismethylamine, 2-[(2-aminoethyl)amino]ethanethiol, bis(2-mercaptoethyl)amine, 2-aminoethane-1-thiol, 1-amino-2-butanol, 1-amino-2-pentanol, L-cysteine, D-cysteine, 3-amino-1-propanol, L-homoserine, D-homoserine, aminohydroxyacetic acid, L-lactic acid, D-lactic acid, L-malic acid, D-malic acid, glyceric acid, 2-hydroxybutyric acid, L-tartaric acid, D-tartaric acid, tartronic acid, 1,2-benzenedithiol, 1,3-benzenedithiol, 1,4-benzenedithiol, 2-mercaptobenzoic acid, 3-mercaptobenzoic acid, 4-mercaptobenzoic acid, and derivatives thereof.

The organic ligand is preferably a compound having 7 or less carbon atoms.

The ligand contained in the ligand may be a ligand that acts as a ligand coordinated to the quantum dot and has a molecular structure that is likely to cause steric hindrance, and also plays a role as a dispersant that disperses the quantum dot in a solvent. Examples of such a ligand include a compound having 8 or more carbon atoms, and a compound having 10 or more carbon atoms is preferable. The ligand may be a saturated compound or may be an unsaturated compound. Specific examples thereof include decanoic acid, lauric acid, myristic acid, palmitic acid, stearic acid, behenic acid, oleic acid, erucic acid, oleylamine, stearylamine, 1-aminodecane, dodecylamine, aniline, dodecanethiol, 1,2-hexadecanethiol, tributylphosphine, trihexylphosphine, trioctylphosphine, tributylphosphine oxide, trioctylphosphine oxide, and cetrimonium bromide.

It is preferable that the ligand contained in the quantum dot dispersion liquid includes at least one selected from an inorganic ligand or a compound having 7 or less carbon atoms. By using such a ligand, the distance between the quantum dots in the semiconductor film can be made closer, and a photodetector having a more excellent external quantum efficiency and the like can be manufactured. In a case where such a ligand is used, soft aggregates of quantum dots tend to be easily formed in the quantum dot dispersion liquid. However, in the present invention, since the quantum dot dispersion liquid is used after being filtered, even in a case where a quantum dot dispersion liquid containing such a ligand is used, a photodetector in which the dark current is reduced can be manufactured with high yield.

The content of the ligand in the quantum dot dispersion liquid is preferably 1% to 15% by mass with respect to the total mass of the quantum dot dispersion liquid. The lower limit thereof is preferably 2% by mass or more and more preferably 2.5% by mass or more. The lower limit thereof is preferably 10% by mass or less and more preferably 7% by mass or less.

In addition, the content of the ligand in the quantum dot dispersion liquid is preferably 10 to 150 mg/mL. The lower limit thereof is preferably 20 mg/mL or more and more preferably 25 mg/mL or more. The upper limit thereof is preferably 100 mg/mL or less and more preferably 70 mg/mL or less.

The quantum dot dispersion liquid contains a solvent. The solvent is not particularly limited, but is preferably a solvent in which the quantum dots are hardly dissolved. The solvent is preferably an organic solvent. Specific examples thereof include alkanes (n-hexane, n-octane, and the like), alkenes (octadecene and the like), benzene, and toluene. The solvent contained in the quantum dot dispersion liquid may be of only one kind or may be a mixed solvent in which two or more kinds of the solvents are mixed.

A content of the solvent in the quantum dot dispersion liquid is preferably 50% to 99% by mass, more preferably 70% to 99% by mass, and still more preferably 90% to 98% by mass.

In the method for manufacturing a photodetector according to the embodiment of the present invention, the quantum dot dispersion liquid is used after being filtered. More preferably, the semiconductor film containing quantum dots is formed using the quantum dot dispersion liquid that has been filtered immediately before the formation of the semiconductor film.

The pore diameter of the filter used for filtration is preferably 0.5 µm or less, more preferably less than 0.45 µm, and still more preferably 0.4 µm or less.

Examples of a material of a filter used for filtration include a fluororesin such as polytetrafluoroethylene (PTFE) and polyvinylidene fluoride (PVDF), a polyamide such as nylon (for example, nylon-6 and nylon-6,6), polyethylene phthalate, a polyolefin resin, and a polyimide resin. Among these materials, for a reason that impurities such as elution products due to the filter are less likely to be generated, a fluororesin or polyamide is preferable, and polytetrafluoroethylene or nylon is more preferable.

The filtration of the quantum dot dispersion liquid is preferably performed in an environment in which the quantum dot dispersion liquid does not come into contact with the atmosphere. For example, it is preferable to carry out the treatment in an inert gas atmosphere or in a reduced pressure environment.

Examples of one aspect of the method for forming the semiconductor film by using the filtered quantum dot dispersion liquid include a method for filtering the quantum dot dispersion liquid taken out from a storage container immediately before the application, recovering the filtered quantum dot dispersion liquid in a container such as a bottle, and forming the semiconductor film by using the recovered quantum dot dispersion liquid.

In addition, examples of another aspect thereof include a method for providing a filter on a flow path of the quantum dot dispersion liquid or an outlet of the quantum dot dispersion liquid in a semiconductor film manufacturing apparatus, and forming the semiconductor film using the quantum dot dispersion liquid that has passed through the filter.

The filtration may be carried out only once or twice or more times. In a case where the filtration is carried out twice or more, the materials of the filters used for the respective filtrations may be the same or different from each other. A temperature of the filtration is preferably 0°C or higher. The upper limit is preferably 100°C or lower, more preferably 80°C or lower, and still more preferably 60°C or lower. The filtration may be carried out under pressure or under reduced pressure. In a case where a pump or the like is used, the lower limit of the pump pressure for filtration can be set to 20 kPa, and the upper limit thereof can be set to 1000 kPa. The filtration pressure of the filtration is preferably 0 kPa or more. The upper limit can be set to 800 kPa. The filtration may be performed by circulation filtration.

The semiconductor film can be formed through a step of applying a quantum dot dispersion liquid.

The method for applying the dispersion liquid is not particularly limited. Examples thereof include coating methods such as a spin coating method, a dipping method, an ink jet method, a dispenser method, a screen printing method, a relief printing method, an intaglio printing method, and a spray coating method.

After forming a film of an aggregate of quantum dots by applying the quantum dot dispersion liquid, a step of applying a ligand solution to the above-described film may be performed. In a case where this step is performed, the ligand coordinated to the quantum dot can be exchanged with a ligand contained in the ligand solution, or a ligand contained in the ligand solution can be coordinated to the quantum dot to suppress the generation of surface defects of the quantum dot. The step of applying the quantum dot dispersion liquid and the step of applying the ligand solution may be alternately repeated a plurality of times.

Examples of the ligand contained in the ligand solution include the above-described inorganic ligand and organic ligand. The organic ligand is preferably a ligand represented by any of Formulae (A) to (C) described above.

The ligand contained in the ligand solution may be the same as or different from the ligand contained in the quantum dot dispersion liquid. The ligand solution may contain only one kind or two or more kinds of the ligands. In addition, in the step of applying the ligand solution, two or more kinds of the ligand solutions may be used.

The solvent contained in the ligand solution is preferably selected appropriately according to the kind of the ligand contained in each ligand solution, and is preferably a solvent that easily dissolves each ligand. In addition, the solvent contained in the ligand solution is preferably an organic solvent having a high dielectric constant. Specific examples thereof include ethanol, acetone, methanol, acetonitrile, dimethylformamide, dimethyl sulfoxide, butanol, and propanol. In addition, the solvent contained in the ligand solution is preferably a solvent that does not easily remain in the formed quantum dot layer. From the viewpoints of easy drying and easy removal by washing, a low boiling point alcohol, a ketone, or a nitrile is preferable, and methanol, ethanol, acetone, or acetonitrile is more preferable. The solvent contained in the ligand solution is preferably one that does not mix with the solvent contained in the quantum dot dispersion liquid. With regard to a preferred combination of the solvents, in a case where the solvent contained in the quantum dot dispersion liquid is an alkane such as hexane and octane, or toluene, it is preferable to use a polar solvent such as methanol and acetone as the solvent contained in the ligand solution.

A step of bringing a rinsing liquid into contact with the film (rinsing step) to rinse after performing the step of applying the ligand may be performed. In addition, the rinsing step may be performed a plurality of times by using two or more kinds of rinsing liquids that differ in polarity (relative permittivity). For example, it is preferable that first, a rinsing liquid having a high relative permittivity (also referred to as a first rinsing liquid) is used to perform rinsing, and then a rinsing liquid having a relative permittivity lower than that of the first rinsing liquid (also referred to as a second rinsing liquid) is used to perform rinsing. The relative permittivity of the first rinsing liquid is preferably 15 to 50, more preferably 20 to 45, and still more preferably 25 to 40. The relative permittivity of the second rinsing liquid is preferably 1 to 15, more preferably 1 to 10, and still more preferably 1 to 5.

A drying step may be performed in the formation of the semiconductor film. The drying time is preferably 1 to 100 hours, more preferably 1 to 50 hours, and still more preferably 5 to 30 hours. The drying temperature is preferably 10°C to 100°C, more preferably 20°C to 90°C, and still more preferably 20°C to 60°C. The drying step may be performed in an atmosphere containing oxygen or in a nitrogen atmosphere.

### <<Step of Forming Second Electrode>>

In the step of forming the second electrode, the second electrode is formed on the semiconductor film. In a case where another layer such as a charge transport layer or a blocking layer, which will be described later, is further formed on the semiconductor film, the second electrode is formed on the other layer after the other layer is formed.

Examples of a material for the second electrode include a metal, an alloy, a metal oxide, a metal nitride, a metal boride, and an organic conductive compound. Specific examples thereof include tin oxide, zinc oxide, indium oxide, indium tungsten oxide, indium zinc oxide (IZO), indium tin oxide (ITO), and fluorine-doped tin oxide (FTO). In a case where the second electrode is provided on the light incident side of the semiconductor film, it is preferable that the second electrode is a transparent electrode formed of a conductive material that is substantially transparent to the wavelength of the target light to be detected by the photodetector.

The second electrode can be formed by a method such as a vacuum deposition method, a sputtering method, or a chemical vapor deposition method (CVD method).

The effects of the present invention are more remarkably exhibited in a case where the second electrode is formed by a sputtering method. In particular, in a case where the second electrode including indium tin oxide is formed by a sputtering method, the effects of the present invention are particularly remarkably exhibited.

In a case where the second electrode is formed by a sputtering method in a case where the semiconductor film has unevenness, the second electrode is easily formed to follow the unevenness of the semiconductor film, and the dark current is more likely to increase. In particular, in a case where the indium tin oxide is formed by a sputtering method, the dark current is likely to be larger. However, according to the present invention, a semiconductor film in which the generation of unevenness is suppressed can be formed. Therefore, even in a case where the second electrode is formed by a sputtering method, a photodetector in which the dark current is reduced can be manufactured with high yield, and the effect of the present invention is more significantly exhibited. Furthermore, by forming the second electrode using a sputtering method, an effect of obtaining a dense and highly conductive film is also obtained. In particular, such an effect is more remarkably obtained in a case where indium tin oxide is formed by a sputtering method.

A thickness of the second electrode is preferably 10 to 100,000 nm. A lower limit thereof is preferably 30 nm or more, and more preferably 50 nm or more. An upper limit thereof is preferably 10,000 nm or less, and more preferably 1,000 nm or less.

### <<Step of Forming Other Layers>>

The method for manufacturing a photodetector according to the embodiment of the present invention may include a step of forming a charge transport layer. Examples of the charge transport layer include a hole transport layer and an electron transport layer.

The electron transport layer is a layer having a function of transporting electrons generated in the semiconductor film to the electrode. The electron transport layer is also called a hole block layer. The electron transport layer is formed of an electron transport material capable of exhibiting this function.

Examples of the electron transport material include a fullerene compound such as [6,6]-phenyl-C61-butyric acid methyl ester (PC61BM), a perylene compound such as perylenetetracarboxylic diimide, tetracyanoquinodimethane, titanium oxide, tin oxide, zinc oxide, indium oxide, indium tungsten oxide, indium zinc oxide, indium tin oxide, and fluorine-doped tin oxide. The electron transport material may be a particle.

It is also preferable that the electron transport layer is composed of a layer including zinc oxide doped with a metal atom other than Zn. Hereinafter, the zinc oxide doped with a metal atom other than Zn is also referred to as the doped zinc oxide.

The metal atom other than Zn in the doped zinc oxide is preferably a monovalent to trivalent metal atom, more preferably a metal atom including at least one selected from Li, Mg, Al, or Ga, still more preferably Li, Mg, Al, or Ga, and particularly preferably Li or Mg.

In the doped zinc oxide, a proportion of the metal atoms other than Zn to a total of Zn and the metal atoms other than Zn is preferably 1% by atom or more, more preferably 2% by atom or more, and still more preferably 4% by atom or more. From the viewpoint of suppressing an increase in crystal defects, an upper limit of the proportion is preferably 20% by atom or less, more preferably 15% by atom or less, and still more preferably 12% by atom or less. Furthermore, a proportion of the metal atoms other than Zn in the doped zinc oxide can be measured according to a high-frequency inductively coupled plasma (ICP) method.

The electron transport layer may be a single-layer film or a laminated film having two or more layers. A thickness of the electron transport layer is preferably 10 to 1,000 nm. An upper limit thereof is preferably 800 nm or less. A lower limit thereof is preferably 20 nm or more, and more preferably 50 nm or more.

The hole transport layer is a layer having a function of transporting holes generated in the semiconductor film to the electrode. The hole transport layer is also called an electron block layer.

The hole transport layer is formed of a hole transport material capable of exhibiting this function. Examples of the hole transport material include PEDOT:PSS (poly(3,4-ethylenedioxythiophene):poly(4-styrenesulfonic acid)), PTB7 (poly {4,8-bis[(2-ethylhexyl)oxy]benzo[1,2-b:4,5-b']dithiophen-2,6-diyl-lt-alt-3-fluoro-2-[(2-ethylhexyl)carbonyl]thieno[3,4-b]thiophen-4,6-diyl}), PTB7-Th (poly([2,6'-4,8-di(5-ethylhexylthienyl)benzo[1,2-b:3,3-b']dithiophen] {3-fluoro-2-[(2-ethylhexyl l)carbonyl]thieno[3,4-b]thiophendiyl})), PC71BM ([6,6]-phenyl-C71-methyl butyrate), and MoO₃. Furthermore, the organic hole transport material disclosed in paragraph Nos. 0209 to 0212 of JP2001-291534A can also be used. In addition, quantum dots can also be used in the hole transport material. Examples of the quantum dot material constituting the quantum dot include a nanoparticle (a particle having a size of 0.5 nm or more and less than 100 nm) of a general semiconductor crystal [a) a Group IV semiconductor, b) a compound semiconductor of Group IV-IV, Group III-V, or Group II-VI, or c) a compound semiconductor consisting of a combination of three or more of a Group II element, a Group III element, a Group IV element, a Group V element, and a Group VI element]. Specific examples thereof include semiconductor materials having a relatively narrow band gap, such as PbS, PbSe, PbSeS, InN, Ge, InAs, InGaAs, CuInS, CuInSe, CuInGaSe, InSb, HgTe, HgCdTe, Ag₂S, Ag₂Se, Ag₂Te, SnS, SnSe, SnTe, Si, and InP. A ligand may be coordinated to a surface of the quantum dot.

A thickness of the hole transport layer is preferably 5 to 200 nm. A lower limit thereof is preferably 10 nm or more. An upper limit thereof is preferably 100 nm or less and more preferably 50 nm or less.

The charge transport layer can be formed by a method such as a vacuum deposition method such as ion plating or ion beam, a sputtering method, or a chemical vapor deposition method (CVD method). In addition, the charge transport layer can also be formed by applying a composition including a charge transport material such as an electron transport material or a hole transport material. In a case where a composition including particles is used as the composition including a charge transport material, it is preferable to use the composition after filtration before use. Examples of the filter used for the filtration include the filter described as the filter used for filtration of the above-described quantum dot dispersion liquid, and the same applies to the preferred range thereof.

The charge transport layer may be formed between the first electrode and the semiconductor film or may be formed between the semiconductor film and the second electrode. The charge transport layer may be formed between the first electrode and the semiconductor film and between the semiconductor film and the second electrode, respectively. In a case where a charge transport layer is formed between the first electrode and the semiconductor film and between the semiconductor film and the second electrode, respectively, it is preferable that either the charge transport layer formed between the first electrode and the semiconductor film or the charge transport layer formed between the semiconductor film and the second electrode is a hole transport layer and the other is an electron transport layer.

In a case where the charge transport layer is formed between the first electrode and the semiconductor film, the charge transport layer is formed on the first electrode, and then the above-described semiconductor film is formed on the charge transport layer. In addition, in a case where the charge transport layer is formed between the semiconductor film and the second electrode, the charge transport layer is formed on the semiconductor film, and then the second electrode is formed on the charge transport layer.

The method for manufacturing a photodetector according to the embodiment of the present invention may include a step of forming a blocking layer. The blocking layer is a layer having a function of reducing dark current.

Examples of the material that forms the blocking layer include silicon oxide, magnesium oxide, aluminum oxide, calcium carbonate, cesium carbonate, polyvinyl alcohol, polyurethane, titanium oxide, tin oxide, zinc oxide, niobium oxide, and tungsten oxide. The blocking layer may be a single-layer film or a laminated film having two or more layers.

The blocking layer can be formed by a method such as a vacuum deposition method such as ion plating or ion beam, a sputtering method, or a chemical vapor deposition method (CVD method). In addition, the blocking layer can also be formed by applying a composition containing a blocking material such as silicon oxide, magnesium oxide, aluminum oxide, calcium carbonate, cesium carbonate, polyvinyl alcohol, polyurethane, titanium oxide, tin oxide, zinc oxide, niobium oxide, or tungsten oxide. In a case where a composition including particles is used as the composition including a blocking material, it is preferable to use the composition after filtration before use. Examples of the filter used for the filtration include the filter described as the filter used for filtration of the above-described quantum dot dispersion liquid, and the same applies to the preferred range thereof.

The blocking layer may be formed between the first electrode and the semiconductor film or may be formed between the semiconductor film and the second electrode. The blocking layer may be formed between the first electrode and the semiconductor film and between the semiconductor film and the second electrode, respectively.

### <Method for Manufacturing Image Sensor>

The method for manufacturing an image sensor according to the embodiment of the present invention includes the above-described method for manufacturing a photodetector.

The configuration of the image sensor is not particularly limited as long as it comprises the photodetector and it is a configuration that functions as an image sensor. Examples of the photodetector include the above-described photodetector.

The image sensor may include an infrared transmitting filter layer. The infrared transmitting filter layer preferably has a low light transmittance in the wavelength band of the visible region, more preferably has an average light transmittance of 10% or less, still more preferably 7.5% or less, and particularly preferably 5% or less, in a wavelength range of 400 to 650 nm.

Examples of the infrared transmitting filter layer include those composed of a resin film containing a coloring material. Examples of the coloring material include a chromatic coloring material such as a red coloring material, a green coloring material, a blue coloring material, a yellow coloring material, a purple coloring material, and an orange coloring material, and a black coloring material. It is preferable that the coloring material contained in the infrared transmitting filter layer forms a black color with a combination of two or more kinds of chromatic coloring materials or is a coloring material containing a black coloring material. Examples of the combination of the chromatic coloring material in a case of forming a black color by a combination of two or more kinds of chromatic coloring materials include the following aspects (C1) to (C7).
(C1) An aspect containing a red coloring material and a blue coloring material.
(C2) An aspect containing a red coloring material, a blue coloring material, and a yellow coloring material.
(C3) An aspect containing a red coloring material, a blue coloring material, a yellow coloring material, and a purple coloring material.
(C4) An aspect containing a red coloring material, a blue coloring material, a yellow coloring material, a purple coloring material, and a green coloring material.
(C5) An aspect containing a red coloring material, a blue coloring material, a yellow coloring material, and a green coloring material.
(C6) An aspect containing a red coloring material, a blue coloring material, and a green coloring material.
(C7) An aspect containing a yellow coloring material and a purple coloring material.

The chromatic coloring material may be a pigment or a dye. The chromatic coloring material may contain a pigment and a dye. The black coloring material is preferably an organic black coloring material. Examples of the organic black coloring material include a bisbenzofuranone compound, an azomethine compound, a perylene compound, and an azo compound.

The infrared transmitting filter layer may further contain an infrared absorber. In a case where the infrared absorber is contained in the infrared transmitting filter layer, the wavelength of the light to be transmitted can be shifted to the longer wave side. Examples of the infrared absorber include a pyrrolo pyrrole compound, a cyanine compound, a squarylium compound, a phthalocyanine compound, a naphthalocyanine compound, a quaterrylene compound, a merocyanine compound, a croconium compound, an oxonol compound, an iminium compound, a dithiol compound, a triarylmethane compound, a pyrromethene compound, an azomethine compound, an anthraquinone compound, a dibenzofuranone compound, a dithiolene metal complex, a metal oxide, and a metal boride.

The spectral characteristics of the infrared transmitting filter layer can be appropriately selected according to the use application of the image sensor. Examples of the filter layer include those that satisfy any one of the following spectral characteristics of (1) to (5).
(1): A filter layer in which the maximum value of the light transmittance in the film thickness direction in a wavelength range of 400 to 750 nm is 20% or less (preferably 15% or less and more preferably 10% or less), and the minimum value of the light transmittance in the film thickness direction in a wavelength range of 900 to 1,500 nm is 70% or more (preferably 75% or more and more preferably 80% or more).
(2): A filter layer in which the maximum value of the light transmittance in the film thickness direction in a wavelength range of 400 to 830 nm is 20% or less (preferably 15% or less and more preferably 10% or less), and the minimum value of the light transmittance in the film thickness direction in a wavelength range of 1,000 to 1,500 nm is 70% or more (preferably 75% or more and more preferably 80% or more).
(3): A filter layer in which the maximum value of the light transmittance in the film thickness direction in a wavelength range of 400 to 950 nm is 20% or less (preferably 15% or less and more preferably 10% or less), and the minimum value of the light transmittance in the film thickness direction in a wavelength range of 1,100 to 1,500 nm is 70% or more (preferably 75% or more and more preferably 80% or more).
(4): A filter layer in which the maximum value of the light transmittance in the film thickness direction in a wavelength range of 400 to 1,100 nm is 20% or less (preferably 15% or less and more preferably 10% or less), and the minimum value thereof in a wavelength range of 1,400 to 1,500 nm is 70% or more (preferably 75% or more and more preferably 80% or more).
(5): A filter layer in which the maximum value of the light transmittance in the film thickness direction in a wavelength range of 400 to 1,300 nm is 20% or less (preferably 15% or less and more preferably 10% or less), and the minimum value thereof in a wavelength range of 1,600 to 2,000 nm is 70% or more (preferably 75% or more and more preferably 80% or more).

Further, as the infrared transmitting filter, the films disclosed in JP2013-077009A, JP2014-130173A, JP2014-130338A, WO2015/166779A, WO2016/178346A, WO2016/190162A, WO2018/016232A, JP2016-177079A, JP2014-130332A, and WO2016/027798A can be used. As the infrared transmitting filter, two or more filters may be used in combination, or a dual bandpass filter that transmits through two or more specific wavelength regions with one filter may be used.

The image sensor may include an infrared shielding filter for the intended purpose of improving various performances such as noise reduction. Specific examples of the infrared shielding filter include the filters disclosed in WO2016/186050A, WO2016/035695A, JP6248945B, WO2019/021767A, JP2017-067963A, and JP6506529B.

The image sensor may include a dielectric multi-layer film. Examples of the dielectric multi-layer film include those in which a plurality of layers are laminated by alternately laminating a dielectric thin film having a high refractive index (a high refractive index material layer) and a dielectric thin film having a low refractive index (a low refractive index material layer). The number of lamination layers of the dielectric thin film in the dielectric multi-layer film is not particularly limited, but is preferably 2 to 100 layers, more preferably 4 to 60 layers, and still more preferably 6 to 40 layers. The material that is used for forming the high refractive index material layer is preferably a material having a refractive index of 1.7 to 2.5. Specific examples thereof include Sb₂O₃, Sb₂S₃, Bi₂O₃, CeO₂, CeF₃, HfO₂, La₂O₃, Nd₂O₃, Pr₆O₁₁, Sc₂O₃, SiO, Ta₂O₅, TiO₂, TiCl, Y₂O₃, ZnSe, ZnS, and ZrO₂. The material that is used for forming the low refractive index material layer is preferably a material having a refractive index of 1.2 to 1.6. Specific examples thereof include Al₂O₃, BiF₃, CaF₂, LaF₃, PbCl₂, PbF₂, LiF, MgF₂, MgO, NdF₃, SiO₂, Si₂O₃, NaF, ThO₂, ThF₄, and Na₃AlF₆. The method for forming the dielectric multi-layer film is not particularly limited; however, examples thereof include ion plating, a vacuum deposition method using an ion beam or the like, a physical vapor deposition method (PVD method) such as sputtering, and a chemical vapor deposition method (CVD method). The thickness of each of the high refractive index material layer and the low refractive index material layer is preferably 0.1 λ to 0.5 λ in a case where the wavelength of the light to be blocked is λ (nm). Specific examples of the usable dielectric multi-layer film include the films disclosed in JP2014-130344A and JP2018-010296A.

In the dielectric multi-layer film, the transmission wavelength band is preferably present in the infrared region (preferably a wavelength region having a wavelength of more than 700 nm, more preferably a wavelength region having a wavelength of more than 800 nm, and still more preferably a wavelength region having a wavelength of more than 900 nm). The maximum transmittance in the transmission wavelength band is preferably 70% or more, more preferably 80% or more, and still more preferably 90% or more. In addition, the maximum transmittance in the shielding wavelength band is preferably 20% or less, more preferably 10% or less, and still more preferably 5% or less. In addition, the average transmittance in the transmission wavelength band is preferably 60% or more, more preferably 70% or more, and still more preferably 80% or more. In addition, in a case where the wavelength at which the maximum transmittance is exhibited is denoted by a central wavelength λₜ₁, the wavelength range of the transmission wavelength band is preferably the central wavelength λₜ₁ ± 100 nm, more preferably the central wavelength λₜ₁± 75 nm, and still more preferably the central wavelength λₜ₁ ± 50 nm.

The dielectric multi-layer film may have only one transmission wavelength band (preferably, a transmission wavelength band having a maximum transmittance of 90% or more) or may have a plurality of transmission wavelength bands.

The image sensor may include a color separation filter layer. Examples of the color separation filter layer include a filter layer including colored pixels. Examples of the kind of colored pixel include a red pixel, a green pixel, a blue pixel, a yellow pixel, a cyan pixel, and a magenta pixel. The color separation filter layer may include colored pixels having two or more colors or having only one color. It can be appropriately selected according to the use application and the intended purpose. For example, the filter disclosed in WO2019/039172A can be used.

In addition, in a case where the color separation layer includes colored pixels having two or more colors, the colored pixels of the respective colors may be adjacent to each other, or a partition wall may be provided between the respective colored pixels. The material of the partition wall is not particularly limited. Examples thereof include organic materials such as a siloxane resin and a fluororesin, and inorganic particles such as a silica particle. In addition, the partition wall may be composed of a metal such as tungsten and aluminum.

It is noted that in a case where the image sensor includes an infrared transmitting filter layer and a color separation layer, it is preferable that the color separation layer is provided on an optical path different from the infrared transmitting filter layer. In addition, it is also preferable that the infrared transmitting filter layer and the color separation layer are disposed two-dimensionally. It is noted that the description that the infrared transmitting filter layer and the color separation layer are disposed two-dimensionally means that at least parts of both are present on the same plane.

The image sensor may include an interlayer such as a planarizing layer, an underlying layer, or an intimate attachment layer, an anti-reflection film, and a lens. As the anti-reflection film, for example, a film produced from the composition disclosed in WO2019/017280A can be used. As the lens, for example, the structure disclosed in WO2018/092600A can be used.

### Examples

Hereinafter, the present invention will be described in detail with reference to Examples. Materials, amounts used, proportions, treatment details, treatment procedures, and the like shown in the following examples can be appropriately changed without departing from the gist of the present invention. Therefore, the scope of the present invention is not limited to the specific examples described below.

### <Quantum Dot Dispersion Liquid>

As the quantum dot dispersion liquid used in Examples and Comparative Examples, a quantum dot dispersion liquid containing a quantum dot, a ligand, and a solvent shown below (concentration of quantum dot: 100 mg/mL, concentration of ligand: 50 mg/mL (30 mg/mL of InBr₃, 20 mg/mL of EDT in quantum dot dispersion liquid 5)) stored at 45°C for 1 month was used. The value of the number average particle diameter of the quantum dots is an average value of the particle diameters of 10 randomly selected quantum dots.

**[Table 1]**

| | Quantum Dot | | | Ligand | Solvent |
|---|---|---|---|---|---|
| | Kind | Maximal Absorption in terms of Absorbance | Diameter | | |
| Quantum Dot Dispersion Liquid 1 | InAs | 1100 nm | 5 nm | MPA | DMF |
| Quantum Dot Dispersion Liquid 2 | InAs | 1100 nm | 5 nm | InBr₃ | DMF |
| Quantum Dot Dispersion Liquid 3 | InAs | 1100 nm | 5 nm | NH₄Cl | DMF |
| Quantum Dot Dispersion Liquid 4 | InAs | 1100 nm | 5 nm | EDT | DMF |
| Quantum Dot Dispersion Liquid 5 | InAs | 1100 nm | 5 nm | InBr₃/EDT | DMF |
| Quantum Dot Dispersion Liquid 6 | InAs | 1400 nm | 8 nm | MPA | DMF |
| Quantum Dot Dispersion Liquid 7 | InGaAs | 1300 nm | 6 nm | MPA | DMF |
| Quantum Dot Dispersion Liquid 8 | InSb | 1200 nm | 4 nm | MPA | DMF |
| Quantum Dot Dispersion Liquid 9 | AgBiS₂ | 1000 nm | 6 nm | MPA | DMF |
| Quantum Dot Dispersion Liquid 10 | AgBiSeTe | 1300 nm | 6 nm | MPA | DMF |
| Quantum Dot Dispersion Liquid 11 | PbS | 1100 nm | 4 nm | Oleic Acid | DMF |
| Quantum Dot Dispersion Liquid 12 | InP | 950 nm | 10 nm | MPA | DMF |
| Quantum Dot Dispersion Liquid 13 | Ge | 1100 nm | 10 nm | MPA | DMF |

| | | | | | |
|---|---|---|---|---|---|
| MPA: 3-mercaptopropionic acid EDT: 1,2-ethanedithiol DMF: N,N-dimethylformamide | | | | | |

### <Production of Zinc Oxide Particle Dispersion Liquid>

1.5 mmol of zinc acetate dihydrate and 15 mL of dimethyl sulfoxide (DMSO) were measured and put in a flask, stirred, and dissolved to obtain a zinc acetate solution.

A tetramethylammonium chloride (TMACl) solution obtained by dissolving 4 mmol of TMAClin 4 mL of methanol and a potassium hydroxide (KOH) solution obtained by dissolving 4 mmol of KOH in 4 mL of methanol were produced. The KOH solution was slowly introduced while vigorously stirring the TMACl solution, and after stirring for 30 minutes, insoluble components were removed through a filter of 0.45 µm to obtain a tetramethylammonium hydroxide (TMAH) solution.

6 mL of the TMAH solution was added to the zinc acetate solution contained in the flask at a dropwise addition rate of 6 mL/min. After being held for 1 hour, the reaction solution was recovered. An excessive amount of acetone was added to the reaction solution, centrifugal separation was carried out at 10,000 rpm for 10 minutes. Then, the supernatant was removed, and the precipitate was dispersed in methanol. Then, the precipitate was precipitated again with acetone, 5 mL of ethanol and 80 µL of aminoethanol were added thereto, and ultrasonic dispersion was carried out to obtain a zinc oxide particle dispersion liquid in which the concentration of the non-doped zinc oxide particles was 30 mg/mL.

### <Manufacture of Photodetector>

### (Example 1)

An indium tin oxide (ITO) film having a thickness of about 100 nm was formed on a quartz glass by a sputtering method to form a first electrode layer.

Next, the ITO film (first electrode) was subjected to spin coating with a solution obtained by dissolving 1 g of zinc acetate dihydrate and 284 µl of ethanolamine in 10 ml of methoxyethanol at 3,000 rpm. Then, heating was carried out at 200°C for 30 minutes to form a sol-gel film of zinc oxide having a thickness of about 40 nm. Next, a step of dropwise adding the zinc oxide particle dispersion liquid 1 onto the sol-gel film, carrying out spin coating at 2,500 rpm, and carrying out heating at 70°C for 30 minutes was carried out twice. Then, using UVO-CLEANER MODEL 144AX-100 manufactured by Jelight Co Inc., an ultraviolet ozone treatment was carried out for 5 minutes under a condition of 30 mW/cm² (wavelength peak: 254 nm) to form a particle film of zinc oxide having a thickness of about 130 nm, whereby an electron transport layer was formed. The zinc oxide particle dispersion liquid was filtered immediately before application by attaching a filter (material: polytetrafluoroethylene (PTFE)) having a pore diameter of 0.2 µm to the tip of the pipette used for application. The filtration was carried out in the atmosphere.

Next, the quantum dot dispersion liquid 1 was added dropwise onto the electron transport layer, and then spin coating was carried out at 1,000 rpm, followed by drying at 60°C for 10 minutes to form a semiconductor film (quantum dot film). By repeating this step 6 times, a semiconductor film having a thickness of 220 nm was formed. Next, the semiconductor film was dried in a glove box for 10 hours to form a photoelectric conversion layer. The quantum dot dispersion liquid 1 was filtered immediately before application by attaching a filter (material: polytetrafluoroethylene (PTFE)) having a pore diameter of 0.2 µm to the tip of the pipette used for application. The filtration was carried out in an inert atmosphere.

Next, a dichlorobenzene solution of PTB7 (poly({4,8-bis[(2-ethylhexyl)oxy]benzo[1,2-b:4,5-b']dithiophen-2,6-diyl} {3-fluoro-2-[(2-ethylhexyl)carbonyl]thieno[3,4-b]thiophendiyl})) (concentration: 5 mg/mL) was spin-coated at 2,000 rpm onto the photoelectric conversion layer, and then dried in a glove box for 10 hours to form a hole transport layer.

Next, a MoO₃ film having a thickness of 5 nm was formed on the hole transport layer by a vacuum deposition method through a metal mask, and then an Au film (the second electrode) having a thickness of 100 nm was formed to manufacture a photodiode-type photodetector.

### (Examples 2 to 6, 8, 13, 15, and 16)

Photodetectors were manufactured in the same manner as in Example 1, except that the type of the quantum dot dispersion liquid used for forming the semiconductor film and filtration conditions were changed as shown in the table below.

### (Example 7)

A photodetector was manufactured in the same manner as in Example 1, except that a second electrode was formed by forming an indium tin oxide (ITO) film having a thickness of about 100 nm on the hole transport layer by a sputtering method in Example 1.

### (Example 14)

A photodetector was manufactured in the same manner as in Example 1, except that the photoelectric conversion layer was formed as follows.

The quantum dot dispersion liquid 11 was added dropwise onto the electron transport layer and spin-coated at 2,500 rpm to form a quantum dot aggregate film (step 1). Next, a methanol solution (concentration: 0.1 mol/L) of 3-mercaptopropionic acid as the ligand solution was added dropwise onto the quantum dot aggregate film, allowed to stand for 1 minute, and spin-dried at 2,500 rpm. Next, methanol was added dropwise onto the quantum dot aggregate film, and the film was spin-dried at 2,500 rpm for 20 seconds to carry out the ligand exchange of the ligand coordinated to the quantum dot from oleic acid to 3-mercaptopropionic acid (step 2). An operation in which step 1 and step 2 were performed as one cycle was repeated for 30 cycles, and a semiconductor film which was a quantum dot aggregate film in which the ligand was exchanged from oleic acid to mercaptopropionic acid was formed to a thickness of 220 nm. Next, the semiconductor film was dried in a glove box for 10 hours to form a photoelectric conversion layer. The quantum dot dispersion liquid 11 was filtered using a filter (material: polytetrafluoroethylene (PTFE)) having a pore diameter of 0.2 µm immediately before use.

### (Comparative Example 1)

A photodetector was manufactured in the same manner as in Example 1, except that regarding the quantum dot dispersion liquid 1 used for forming the semiconductor film, the semiconductor film was formed using the quantum dot dispersion liquid 1 that had not been filtered.

### (Comparative Example 2)

A photodetector was manufactured in the same manner as in Example 7, except that regarding the quantum dot dispersion liquid 1 used for forming the semiconductor film, the semiconductor film was formed using the quantum dot dispersion liquid 1 that had not been filtered.

### <Evaluation of Yield>

The dark current was measured for 100 photodetectors using a semiconductor parameter analyzer (4156C, manufactured by Keysight Technologies, Inc.). The current flowing through the element in a case where 0 V was applied to the first electrode and -1 V was applied to the second electrode in a light shielding atmosphere was measured. Since the measurement was carried out in an inert atmosphere, the measurement was carried out in a glove box in a nitrogen atmosphere.
A: The proportion of photodetectors having a dark current of 50 nA/cm² or less is 80% or more.
B: The proportion of photodetectors having a dark current of 50 nA/cm² or less is 50% or more and less than 80%.
C: The proportion of photodetectors having a dark current of 50 nA/cm² or less is 30% or more and less than 50%.
D: The proportion of photodetectors having a dark current of 50 nA/cm² or less is less than 30%.

**[Table 2]**

| | Kind of Quantum Dot Dispersion Liquid | Presence or Absence of Filtration | Kind of Filter | | Second Electrode | Yield |
|---|---|---|---|---|---|---|
| | | | Material | Pore Diameter | | |
| Example 1 | Quantum Dot Dispersion Liquid 1 | Presence | PTFE | 0.2 µm | MoO₃+Au | A |
| Example 2 | Quantum Dot Dispersion Liquid 2 | Presence | PTFE | 0.2 µm | MoO₃+Au | A |
| Example 3 | Quantum Dot Dispersion Liquid 3 | Presence | PTFE | 0.2 µm | MoO₃+Au | A |
| Example 4 | Quantum Dot Dispersion Liquid 4 | Presence | PTFE | 0.2 µm | MoO₃+Au | A |
| Example 5 | Quantum Dot Dispersion Liquid 5 | Presence | PTFE | 0.2 µm | MoO₃+Au | A |
| Example 6 | Quantum Dot Dispersion Liquid 6 | Presence | PTFE | 0.2 µm | MoO₃+Au | A |
| Example 7 | Quantum Dot Dispersion Liquid 1 | Presence | PTFE | 0.2 µm | ITO | A |
| Example 8 | Quantum Dot Dispersion Liquid 1 | Presence | Nylon | 0.2 µm | MoO₃+Au | A |
| Example 9 | Quantum Dot Dispersion Liquid 1 | Presence | PTFE | 0.45 µm | MoO₃+Au | B |
| Example 10 | Quantum Dot Dispersion Liquid 7 | Presence | PTFE | 0.2 µm | MoO₃+Au | A |
| Example 11 | Quantum Dot Dispersion Liquid 8 | Presence | PTFE | 0.2 µm | MoO₃+Au | A |
| Example 12 | Quantum Dot Dispersion Liquid 9 | Presence | PTFE | 0.2 µm | MoO₃+Au | A |
| Example 13 | Quantum Dot Dispersion Liquid 10 | Presence | PTFE | 0.2 µm | MoO₃+Au | A |
| Example 14 | Quantum Dot Dispersion Liquid 11 | Presence | PTFE | 0.2 µm | MoO₃+Au | A |
| Example 15 | Quantum Dot Dispersion Liquid 12 | Presence | PTFE | 0.2 µm | MoO₃+Au | A |
| Example 16 | Quantum Dot Dispersion Liquid 13 | Presence | PTFE | 0.2 µm | MoO₃+Au | A |
| Comparative Example 1 | Quantum Dot Dispersion Liquid 1 | Absence | - | - | MoO₃+Au | C |
| Comparative Example 2 | Quantum Dot Dispersion Liquid 1 | Absence | - | - | ITO | D |

As shown in the above table, in Examples, photodetectors in which the dark current was suppressed could be manufactured with high yield.

In a case of manufacturing an image sensor using the photodetector obtained in Examples by using an optical filter produced according to the method described in WO2016/186050A and WO2016/190162A and together with a publicly known method, it is possible to obtain an image sensor having good visible and infrared imaging performance.

## Claims

1. A method for manufacturing a photodetector, comprising:
forming a first electrode on a support;
filtering a quantum dot dispersion liquid containing quantum dots having a maximal absorption in terms of absorbance in a wavelength range of 900 to 1700 nm, a ligand, and a solvent, and forming a semiconductor film containing the quantum dots on the first electrode by using the filtered quantum dot dispersion liquid; and
forming a second electrode on the semiconductor film.

2. The method for manufacturing a photodetector according to claim 1,
wherein in the quantum dot dispersion liquid, a content of the quantum dots in a component obtained by removing the solvent and the ligand from the quantum dot dispersion liquid is 50% by mass or more.

3. The method for manufacturing a photodetector according to claim 1 or 2,
wherein a pore diameter of a filter used for filtering the quantum dot dispersion liquid is less than 0.45 µm.

4. The method for manufacturing a photodetector according to claim 1 or 2,
wherein a material of a filter used for filtering the quantum dot dispersion liquid includes at least one selected from a fluororesin, a polyamide, or polyethylene terephthalate.

5. The method for manufacturing a photodetector according to claim 1 or 2,
wherein the quantum dots contain at least one atom selected from the group consisting of Ga, Ge, As, Se, In, Sb, Ag, Te, and Bi.

6. The method for manufacturing a photodetector according to claim 1 or 2,
wherein the ligand includes at least one selected from an inorganic ligand or a compound having 7 or less carbon atoms.

7. The method for manufacturing a photodetector according to claim 1 or 2,
wherein the ligand includes an inorganic ligand, and the inorganic ligand is an inorganic halide.

8. The method for manufacturing a photodetector according to claim 1 or 2,
wherein a number average particle diameter of the quantum dots is 4 nm or more.

9. The method for manufacturing a photodetector according to claim 1 or 2,
wherein the second electrode is formed on the semiconductor film by a sputtering method.

10. The method for manufacturing a photodetector according to claim 1 or 2,
wherein the second electrode contains indium tin oxide.

11. A method for manufacturing an image sensor, comprising:
the method for manufacturing a photodetector according to claim 1 or 2.
